(19) Europäisches Patentamt

European Patent Office

Office européen des brevets

(11) **EP 1 203 961 B1**

(12) **EUROPÄISCHE PATENTSCHRIFT**

(45) Veröffentlichungstag und Bekanntmachung des Hinweises auf die Patenterteilung:
**01.03.2006 Patentblatt 2006/09**

(51) Int Cl.:
***G01R 15/18*** *(2006.01)*

(21) Anmeldenummer: **00811038.9**

(22) Anmeldetag: **06.11.2000**

(54) **Verfahren zum Messen des Widerstands und der Induktivität einer Leitung**

Process for measuring the resistance and inductivity of a line

Méthode de mesure de la résistance et de l'inductivité d'une ligne

(84) Benannte Vertragsstaaten:
**AT BE CH CY DE DK ES FI FR GB GR IE IT LI LU MC NL PT SE TR**

(43) Veröffentlichungstag der Anmeldung:
**08.05.2002 Patentblatt 2002/19**

(73) Patentinhaber: **ABB RESEARCH LTD.**
**8050 Zürich (CH)**

(72) Erfinder:
• **Stanimirov, Michael**
**5400 Baden (CH)**
• **Deck, Bernhard**
**79809 Weilheim (DE)**
• **Rueegg, Walter**
**5304 Endingen (CH)**

(74) Vertreter: **ABB Patent Attorneys**
**c/o ABB Schweiz AG**
**Brown Boveri Strasse 6**
**5400 Baden (CH)**

(56) Entgegenhaltungen:
**DD-A- 216 547      DE-A- 4 204 515**

**Beschreibung**

Technisches Gebiet

Die Erfindung betrifft ein Verfahren zum Messen des Widerstands und der Induktivität einer Leitung gemäss Oberbegriff von Anspruch 1. Derartige Verfahren werden z.B. zur Kurzschlussdetektion in Stromversorgungsleitungen verwendet.

Stand der Technik

Um die Impedanz und insbesondere den Widerstand und die Induktivität einer Leitung zu bestimmen, werden in der Regel der in ihr fliessende Strom und die über sie anliegende Spannung zeitaufgelöst gemessen rechnerisch in die gesuchten Werte umgewandelt. Zur Strommessung wird, insbesondere bei Starkstromleitungen, neuerdings auch eine Rogowski-Spule eingesetzt, d.h. eine sich um die stromführende Leitung erstreckende Spule, die die Ableitung des Stroms nach der Zeit misst. Um den Strom zu ermitteln, muss diese Ableitung nach der Zeit integriert werden. Dies erfordert zusätzlichen numerischen Aufwand und kann zu Ungenauigkeiten führen (Clippingeffekte, Phasenversatz).

Darstellung der Erfindung

Es stellt sich deshalb die Aufgabe, ein Verfahren der eingangs genannten Art bereitzustellen, welches eine möglichst genaue und einfache Möglichkeit zur Messung der Induktivität und des Widerstands erlaubt.
Diese Aufgabe wird vom Verfahren gemäss Anspruch 1 gelöst. Anstelle einer Integration der Werte von der Rogowski-Spule werden die gemessenen Werte also direkt in ein Gleichungssystem eingesetzt, welches die gewünschten Resultate liefert.
Vorzugsweise wird eine grössere Zahl von Messwerten verwendet, so dass das Gleichungssystem überbestimmt wird. Der Widerstand und die Induktivität können sodann mit Ausgleichsrechnung ermittelt werden. Vorzugsweise werden die Fehlerquadrate minimiert, was mittels einfacher Matrixinversion oder rekursiv möglich ist.

Kurze Beschreibung der Zeichnung

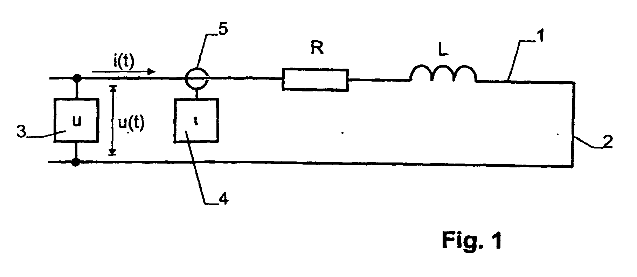

Weitere Ausgestaltungen, Vorteile und Anwendungen der Erfindung ergeben sich aus den abhängigen Ansprüchen und aus der nun folgenden Beschreibung anhand der Figur 1. Dabei zeigt die Figur ein Ersatzschaltbild für eine zu messende Leitung.

Wege zur Ausführung der Erfindung

Fig. 1 zeigt das Ersatzschaltbild für eine Leitung 1 mit Widerstand R und Induktivität L. Dabei kann es sich z.B. um eine an einem Punkt 2 kurzgeschlossene Starkstromleitung handeln.
Zur Messung der Spannung u(t) über der Leitung 1 ist ein Spannungsmessgerät 3 vorgesehen. Dabei kann es sich z.B. um einen elektro-optischen Spannungsumwandler handeln, der (ggf. bis auf eine bekannte Eichkonstante) den Wert der Spannung u(t) direkt wiederzugeben vermag.
Zur Messung des Stroms $i(t)$ bzw. in der Leitung 1 wird ein Stromdifferenzial-Messgerät 4 verwendet. Dieses umfasst eine Rogowski-Spule 5, die eine Spannung proportional zur Zeitableitung $\partial/\partial t$ von $i(t)$ erzeugt. Entsprechend erzeugt das Stromdifferenzial-Messgerät 4 Messwerte, die (bis auf eine bekannte Eichkonstante) dem Wert $\partial i(t)/\partial t$ ensprechen.

Die Messgeräte 3, 4 werden mit einer Abtastrate $f_A = 1/T_A$ betrieben und liefern eine Reihe von Spannungswerten $u_0\ u_1, ...$ und eine Reihe von Weren $\iota_0, \iota_1, ... \iota_N$ des differenzierten Stroms, wobei $u_k = u(kT_A)$ und $\iota_k = \partial i/\partial t|_{t=kTA}$. Aus diesen Werten sollen der Widerstand $R$ und die Induktivität L bestimmt werden.
Für die Spannung $u(t)$ gilt:

$$u(t) \ = \ R \cdot i(t) \ + \ L \cdot \frac{\partial}{\partial t} \ i(t) \qquad\qquad (1)$$

Mit der Rogowski-Spule wird die zeitliche Ableitung des Stroms $i(t)$ gemessen, d.h. die Grösse

$$\iota(t) \; = \; \frac{\partial}{\partial t} \; i(t) \qquad\qquad (2)$$

Der Strom $i(t)$ kann durch Integration von (2) berechnet werden. Durch Einsetzen in (1) ergibt sich somit:

$$u(t) \; = \; R \, \cdot \, \int \iota(\tau) d\tau \; + \; L \, \cdot \, \iota(t) \qquad\qquad (3)$$

Gleichung (3) lässt sich in diskretisierte Form umwandeln. Vorzugsweise wird die Laplace-Transformierte u(p) gebildet und eine bilineare Transformation $p = A \cdot (z - 1)/(z + 1)$, wobei A im Falle der Tustin-Approximation den Wert $A \cong 2/T_A$ annimmt. Genauer kann A geschrieben werden als

$$A \; = \; \omega_0 \, \cdot \, \cot\!\left(\frac{\omega_0}{2} \, \cdot \, \frac{T_A}{2}\right), \qquad\qquad (3a)$$

wobei $\omega_0$ die Frequenz ist, bei der die digitale Approximation mit den analogen Werten übereinstimmen soll. Bei Verwendung von Formel (3a) anstelle von $A = 2/T_A$ stimmt die Approximation durch das digitale Modell genau mit dem analogen Modell bei der Kreisfrequenz $\omega_0$ überein. In der Praxis wird $\omega_0 = 2\pi \cdot f_N$ gewählt, wobei $f_N$ die Netzfrequenz der auf der auszumessenden Leitung liegenden Spannung ist.

Durch Diskretisierung von Gleichung (3) ergibt sich näherungsweise:

$$u_n \; = \; u_{n-1} \; + \; \alpha_0 \, \cdot \, \iota_n \; + \; \alpha_1 \, \cdot \, \iota_{n-1} \qquad\qquad (4)$$

wobei $u_n$ und $u_{n-1}$ zwei nacheinander abgetastete Spannungswerte und $\iota_n$ und $\iota_{n-1}$ zwei nacheinander abgetastete Werte des differenzierten Stroms sind. Die Parameter $\alpha_0$ und $\alpha_1$ sind gegeben durch

$$\begin{aligned} \alpha_0 \; &= \; \frac{R}{A} \; + \; L \\[2mm] \alpha_1 \; &= \; \frac{R}{A} \; - \; L \end{aligned} \qquad\qquad (5)$$

Gleichung (4) bildet eine Grundlage zur Ermittlung der gesuchten Werte R und L bzw. der Parameter $\alpha_0$ und $\alpha_1$. Hierzu werden N Messungen der Spannung $\{u_1, u_2, ... u_N\}$ und des differenzierten Stroms $\{\iota_1, \iota_2, ... \iota_N\}$ mit $N \geq 3$ benötigt, um aus (4) ein Gleichungssystem mit $N$-1 Gleichungen für $\alpha_0$ und $\alpha_1$ aufzustellen, so dass die Parameter berechnet werden können. Dieses Vorgehen hat den Vorteil, dass eine direkte Integration von Gleichung (3) umgangen werden kann.

Aus den Parametern $\alpha_0$ und $\alpha_1$ können sodann der Widerstand R und die Induktivität L bestimmt werden aus

$$R = A \cdot \frac{(\alpha_0 + \alpha_1)}{2}$$
$$L = \frac{\alpha_0 - \alpha_1}{2} \tag{6}$$

Vorzugsweise ist N > 3, d.h. es werden mehr als zwei Gleichungen aufgestellt, so dass ein überbestimmtes Gleichungssystem entsteht. Die Parameterwerte können in diesem Falle mittels Ausgleichsrechung mit hoher Genauigkeit bestimmt werden.

Beispielsweise können die Parameter $\alpha_0$ und $\alpha_1$ bestimmt werden durch Minimieren der Fehlerquadrate der linearen Gleichungen (4) für n = 1 ... N, was in Vektorschreibweise zu folgender Lösung führt:

$$\Theta = \begin{pmatrix} \alpha_0 \\ \alpha_1 \end{pmatrix} = \left[ \sum_{n=1}^{N} m_n m_n^T \right]^{-1} \cdot \sum_{n=1}^{N} m_n y_n \tag{7}$$

mit

$$m_n = \begin{pmatrix} \iota_n \\ \iota_{n-1} \end{pmatrix}$$

und

$$y_n = (u_n - u_{n-1})$$

Dabei ist der erste Multiplikand auf der rechten Seite der Gleichung (7) die Inverse einer *2* x *2* - Matrix erzeugt aus den Werten $\iota_k$ des differenzierten Stroms, während der zweite Multiplikand eine Summe von Vektoren aus den Werten $\iota_k$ des differenzierten Stroms gewichtet mit Differenzen aufeinander folgender Spannungswerte $u_k$ ist.

Gleichungssystem (4) kann auch mittels rekursiver Parameterschätzverfahren oder Kalmanfiltern gelöst werden. Ein iteratives Verfahren kann z.B. für jedes Vektorpaar $m_n$, $y_n$ einen neuen Näherungswert $\Theta_n$ für den Parametervektor $\Theta$ aus dem vorhergehenden Näherungswert $\Theta_{n-1}$ berechnen mittels der Rekursionsformel

$$K = P_{n-1} \cdot m_n \cdot \left( \lambda + m_n^T \cdot P_{n-1} \cdot m_n \right)^{-1}$$
$$\Theta_n = \Theta_{n-1} + K \cdot \left( y_n - m_n^T \cdot \Theta_{n-1} \right) \tag{8}$$
$$P_n = \left( E - K \cdot m_n^T \right) \frac{P_{n-1}}{\lambda}$$

Dabei ist E die Einheitsmatrix, $\lambda$ ein Vergessensfaktor zwischen 0.8 und 0.9 und $P_n$ die sog. Präzisionsmatrix (Startwert z.B. $10^3 \cdot E$ oder $10^5 \cdot E$) ist. *K* wird Korrekturfaktor genannt.

Bezugszeichenliste

1: Leitung

2: Kurzschlusspunkt

3: Spannungsmessgerät

4: Stromdifferenzial-Messgerät

5: Rogowski-Spule

A: Faktor

E: Einheitsmatrix

$f_A$: Abtastrate

$i(t)$: Zeitabhängiger Strom

$K$: Korrekturfaktor

L: Induktivität

N: Zahl der Messwerte innerhalb des Beobachtungsfensters

R: Widerstand

$T_A$: Zeitabstand zwischen Messwerten

u(t): Spannung

$u_k$: Spannungswerte

$\dot{\imath}(t)$: Zeitdifferenzierter Strom

$\dot{\imath}_k$: Werte des differenzierten Stromes

$\alpha_0, \alpha_1$: Parameterwerte

$\lambda$: Vergessensfaktor

$\Theta$: Parametervektor

**Patentansprüche**

**1.** Verfahren zum Messen des Widerstands R und der Induktivität $L$ einer Leitung, bei welchem eine Spannung u über der Leitung und eine zeitliche Ableitung $i(t)$ des Stroms durch die Leitung mit einer Rate $1/T_A$ gemessen werden um eine Reihe von N Spannungswerten $u_0, u_1, ... u_N$ und eine Reihe von N Werten $\dot{\imath}_0, \dot{\imath}_1, ... \dot{\imath}_N$ des differenzierten Stroms zu erhalten, **dadurch gekennzeichnet, dass** $N \geq 3$ und die Spannungswerte und die Werte des differenzierten Stroms in ein Gleichungssystem mit $N$-1 Gleichungen der Form

$$u_n = u_{n-1} + \alpha_0 \cdot \dot{\imath}_n + \alpha_1 \cdot \dot{\imath}_{n-1}$$

eingesetzt werden, mit Parametern

$$\alpha_0 = \frac{R}{A} + L$$

$$\alpha_1 = \frac{R}{A} - L$$

wobei

$$A \cong 2/T_A$$

oder

$$A = \omega_0 \cdot \cot\left(\frac{\omega_0}{2} \cdot \frac{T_A}{2}\right)$$

und dass aus dem Gleichungssystem der Widerstand R und die Induktivität L ermittelt werden.

2. Verfahren nach Anspruch 1, **dadurch gekennzeichnet, dass** $N \geq 3$ ist und dass der Widerstand R und die Induktivität L durch Ausgleichsrechnung ermittelt werden.

3. Verfahren nach Anspruch 2, **dadurch gekennzeichnet, dass** der Widerstand R und die Induktivität L durch Lösen von

$$\binom{\alpha_0}{\alpha_1} = \left[\sum_{n=1}^{N} m_n m_n^T\right]^{-1} \cdot \sum_{n=1}^{N} m_n y_n$$

mit

$$m_n = \binom{\iota_n}{\iota_{n-1}}$$

und

$$y_n = \left(u_n - u_{n-1}\right)$$

ermittelt werden.

4. Verfahren nach einem der Ansprüche 1 - 3, **dadurch gekennzeichnet, dass** das Gleichungssystem iterative gelöst wird, indem für eine Vielzahl von n ein Näherungswert $\Theta_n$ berechnet wird für

$$\Theta = \binom{\alpha_0}{\alpha_1}$$

aus der Rekursionsformel

$$K = P_{n-1} \cdot m_n \cdot \left( \lambda + m_n^T \cdot P_{n-1} \cdot m_n \right)^{-1}$$

$$\Theta_n = \Theta_{n-1} + K \cdot \left( y_n - m_n^T \cdot \Theta_{n-1} \right)$$

$$P_n = \left( E - K \cdot m_n^T \right) \frac{P_{n-1}}{\lambda}$$

mit

$$m_n = \begin{pmatrix} i_n \\ i_{n-1} \end{pmatrix}$$

und

$$y_n = \left( u_n - u_{n-1} \right)$$

wobei $E$ die Einheitsmatrix, $\lambda$ ein Vergessensfaktor, insbesondere zwischen 0.8 und 0.9, und $P_n$ eine Matrix mit Startwert, vorzugsweise zwischen $10^3 \cdot E$ und $10^5 \cdot E$, ist.

5. Verfahren nach einem der vorangehenden Ansprüche, **dadurch gekennzeichnet, dass** die erste Ableitung des Stroms mit einer Rogowski-Spule gemessen wird.

6. Verfahren nach einem der vorangehenden Ansprüche, **dadurch gekennzeichnet, dass** A = $2/T_A$.

7. Verfahren nach einem der Ansprüche 1 - 5, **dadurch gekennzeichnet, dass**

$$A = \omega_0 \cdot \cot\left( \frac{\omega_0}{2} \cdot \frac{T_A}{2} \right),$$

wobei $\omega_0$ die Kreisfrequenz einer auf der Leitung liegenden Spannung ist.

8. Verwendung des Verfahrens nach einem der vorangehenden Ansprüche zum Messen der Impedanz einer Starkstromleitung.

**Revendications**

1. Procédé pour mesurer la résistance R et l'inductance L d'une ligne avec lequel une tension u sur la ligne et une dérivée dans le temps i(t) du courant à travers la ligne sont mesurées à une fréquence $1/T_A$ afin d'obtenir une série de N valeurs de tension $u_0$, $u_1$, ... $u_N$ et une série de N valeurs $t_0$, $t_1$, ... $t_N$ du courant dérivé, **caractérisé en ce que** N ≥ 3 et les valeurs de la tension ainsi que les valeurs du courant dérivé sont utilisées dans un système de N-1 équations sous la forme

$$u_n = u_{n-1} + \alpha_0 . t_n + \alpha_1 . t_{n-1}$$

avec les paramètres

$$\alpha_0 = R/A + L$$

$$\alpha_1 = R/A - L$$

où

$$A \cong 2/T_A$$

ou

$$A = \omega_0 . \cot\left(\frac{\omega_0}{2} \bullet \frac{T_A}{2}\right)$$

et que la résistance R et l'inductance L sont déterminées à partir du système d'équations.

2. Procédé selon la revendication 1, **caractérisé en ce que** $N \geq 3$ et que la résistance R et l'inductance L sont déterminées par un calcul différentiel.

3. Procédé selon la revendication 2, **caractérisé en ce que** la résistance R et l'inductance L sont déterminées en résolvant

$$\begin{pmatrix} \alpha_0 \\ \alpha_1 \end{pmatrix} = \left[\sum_{n=1}^{N} m_n m_n^T\right]^{-1} \cdot \sum_{n=1}^{N} m_n y_n$$

avec

$$m_n = \begin{pmatrix} t_n \\ t_{n-1} \end{pmatrix}$$

et

$$y_n = (u_n - u_{n-1})$$

4. Procédé selon l'une des revendications 1 à 3, **caractérisé en ce que** le système d'équations est résolu de manière itérative en calculant pour un grand nombre de n une valeur d'approximation $\Theta_n$ pour

$$\Theta = \begin{pmatrix} \alpha_0 \\ \alpha_1 \end{pmatrix}$$

à partir de la formule de récurrence

$$K = P_{n-1} \cdot m_n \cdot (\lambda + m^T_n \cdot P_{n-1} \cdot m_n)^{-1}$$

$$\Theta_n = \Theta_{n-1} + K \cdot (y_n - m^T_n \cdot \Theta_{n-1})$$

$$P_n = (E - K \cdot m^T_n) \frac{P_{n-1}}{\lambda}$$

avec

$$m_n = \begin{pmatrix} t_n \\ t_{n-1} \end{pmatrix}$$

et

$$y_n = (u_n - u_{n-1})$$

E désignant la matrice d'unité, $\lambda$ un facteur d'oubli, notamment entre 0,8 et 0,9, et $P_n$ une matrice avec une valeur de départ, de préférence entre $10^3.E$ et $10^5.E$.

5. Procédé selon l'une des revendications précédentes, **caractérisé en ce que** la première dérivée du courant est mesurée avec une bobine de Rogowski.

6. Procédé selon l'une des revendications précédentes, **caractérisé en ce que** A = $2/T_A$.

7. Procédé selon l'une des revendications 1 à 5, **caractérisé en ce que**

$$A = \omega_0 . \cot\left(\frac{\omega_0}{2} \bullet \frac{T_A}{2}\right)$$

où $\omega_0$ désigne la fréquence angulaire d'une tension appliquée sur la ligne.

8. Utilisation du procédé selon l'une des revendications précédentes pour mesurer l'impédance d'une ligne à courant fort.

**Claims**

1. Method for measuring the resistance R and the inductance L of a line, in which a voltage u across the line and a time derivative $i(t)$ of the current through the line are measured at a rate $1/T_A$ in order to obtain a series of N voltage values $u_0$, $u_1$, ... $u_N$ and a series of N values $i_0$, $i_1$, ... $i_N$ of the differentiated current, **characterized in that** N $\geq$ 3 and the voltage values and the values of the differentiated current are substituted into an equation system with $N$ - 1 equations of the form

$$u_n = u_{n-1} + \alpha_0 \cdot i_n + \alpha_1 \cdot i_{n-1} \,,$$

with parameters

$$\alpha_0 = \frac{R}{A} + \dot{L}$$

$$\alpha_1 = \frac{R}{A} - L$$

where

$$A \cong 2/T_A$$

or

$$A = \omega_0 \cdot \cot\left(\frac{\omega_0}{2} \cdot \frac{T_A}{2}\right),$$

and **in that** the resistance R and the inductance L are found from the equation system.

2. Method according to Claim 1, **characterized in that** N ≥ 3, and **in that** the resistance R and the inductance L are found by adjustment computation.

3. Method according to Claim 2, **characterized in that** the resistance R and the inductance L are found by solving

$$\binom{\alpha_0}{\alpha_1} = \left[\sum_{n=1}^{N} m_n m_n^T\right]^{-1} \cdot \sum_{n=1}^{N} m_n y_n$$

with

$$m_n = \binom{\iota_n}{\iota_{n-1}}$$

and

$$y_n = (u_n - u_{n-1}) \ .$$

4. Method according to one of Claims 1 - 3, **characterized in that** the equation system is solved iteratively by calculating, for a plurality of n, an approximation $\Theta_n$ for

$$\dot{\Theta} = \binom{\alpha_0}{\alpha_1}$$

from the recursion formula

$$K = P_{n-1} \cdot m_n \cdot (\lambda + m_n^T \cdot P_{n-1} \cdot m_n)^{-1}$$

$$\Theta_n = \Theta_{n-1} + K \cdot (y_n - m_n^T \cdot \Theta_{n-1})$$

$$P_n = (E - K \cdot m_n^T) \frac{P_{n-1}}{\lambda}$$

with

$$m_n = \begin{pmatrix} \iota_n \\ \iota_{n-1} \end{pmatrix}$$

and

$$y_n = (u_n - u_{n-1}) \,,$$

where E is the unit matrix, $\lambda$ is a weighting factor, in particular between 0.8 and 0.9, and $P_n$ is a matrix with a start value, preferably, between $10^3 \cdot E$ and $10^5 \cdot E$.

5.  Method according to one of the preceding claims, **characterized in that** the first derivative of the current is measured using a Rogowski coil.

6.  Method according to one of the preceding claims, **characterized in that** $A = 2/T_A$.

7.  Method according to one of Claims 1 - 5, **characterized in that**

$$A = \omega_0 \cdot \cot\left(\frac{\omega_0}{2} \cdot \frac{T_A}{2}\right) \,,$$

where $\omega_0$ is the angular frequency of a voltage along the line.

8.  The use of the method according to one of the preceding claims for measuring the impedance of an electrical power line.

**Fig. 1**